# EUROPEAN PATENT SPECIFICATION

(11) **EP 2 899 801 B1**
(45) Date of publication and mention of the grant of the patent: **04.10.2017**
(21) Application number: 13838786.5
(22) Date of filing: 10.04.2013
(51) Int. Cl.: H01P 1/213, H01P 5/16, H03F 3/60, H04B 1/04, H03F 1/30, H03F 3/19, H03F 3/195, H03F 3/21, H03F 3/24

(54) **POWER-COMBINING CIRCUIT AND POWER-COMBINING METHOD**
LEISTUNGSKOMBINATIONSSCHALTUNG UND LEISTUNGSKOMBINATIONSVERFAHREN
CIRCUIT DE COMBINAISON DE PUISSANCE ET PROCÉDÉ DE COMBINAISON DE PUISSANCE

(30) Priority: 18.09.2012 JP 2012204214
(43) Date of publication of application: 29.07.2015
(73) Proprietor: NEC Corporation, Tokyo 108-8001 (JP)
(72) Inventor: TANIMOTO, Takuya, Tokyo 108-8001 (JP)
(74) Representative: Vossius & Partner Patentanwälte Rechtsanwälte mbB
(86) International application number: PCT/JP2013/002431
(87) International publication number: WO 2014/045484

(56) References cited:
- EP-A1- 0 520 857
- DE-T2- 3 879 905
- JP-A- S5 251 811
- JP-A- H05 102 777
- JP-A- H07 135 609
- JP-A- 2003 209 404
- JP-A- 2006 222 684
- JP-U- H0 436 303
- US-A- 5 933 770
- US-A1- 2001 030 586
- US-B1- 6 304 155
- US-B1- 6 384 680
- POSPISHIL A ET AL: "A MMIC subharmonically pumped SSB modulator", MICROWAVE SYMPOSIUM DIGEST, 1993., IEEE MTT-S INTERNATIONAL ATLANTA, GA, USA 14-18 JUNE 1993, NEW YORK, NY, USA,IEEE, US, 14 June 1993 (1993-06-14), pages 399-402vol.1, XP032370472, DOI: 10.1109/MWSYM.1993.276794 ISBN: 978-0-7803-1209-8

## Description

### [Technical Field]

The present invention relates to a power combining circuit and a power combining method, and more particularly to a power combining circuit and a power combining method for use in a high frequency band such as a VHF band or a UHF band, for instance, a power combining circuit and a power combining method for use in operating high frequency power units such as a power amplifier, a power distributor, a power combiner, and a filter circuit in a TV transmitter, an FM transmitter, or the like in parallel.

### [Background Art]

As a conventional art relating to a power combining circuit configured to combine high frequency powers obtained by operating high frequency power units in a TV transmitter, an FM transmitter, or the like in parallel and to output the combined powers, there is known a technique described in Patent Literature 1 i.e. Japanese Patent Publication No. 2,639,032 entitled "Energy-Coupling Device". The power combining circuit described in Patent Literature 1 is provided with a plurality of amplifiers; a 3dB-hybrid circuit which distributes the signals from each of the amplifiers to two signals having a phase difference of 90 degrees from each other; two couplers which couple the signals, among the distributed signals in phase with each other; and a back-end positioned 3dB-hybrid circuit which distributes the coupled two signals to two signals so that one of the two signals is output to an antenna, and the other of the two signals is terminated at a terminator. The power combining circuit has a simplified configuration, without a filter for removing a spurious component generated in the amplifiers.

PTL 1: JP-2,639,032 A (pages 2-4)

EP 0 520 857 A1 relates to signal diplexers and to means for coupling the energies from sources which provide in-phase signals of like amplitude, wherein the energy coupling means and the diplexer are not mounted in series but nested.

### [Summary of Invention]

### [Technical Problem]

Therefore, in the conventional art described in Patent Literature 1, when power of a high frequency signal is amplified, the signal waveform may be distorted by non-linearity of the amplifiers, and a harmonics may be generated at a frequency of an integral multiple (2-times, 3-times, 4-times, ...) of a fundamental frequency.

Further, in the out-of-band region near an intended wave, a spurious component known as intermodulation distortion (IM) may be generated by non-linearity of the amplifiers. Generally, a filter such as a low-pass filter or a band-pass filter is used in order to output signals, in which a spurious component in the out-of-band region is removed. However, when a spurious component generated in the amplifiers is reflected on the filter and the reflected component returns to the amplifiers, troubles such as a failure of the amplifiers may occur.

### (Object of the Present Invention)

The present invention has been made in view of the above, and an object of the present invention is to provide a power combining circuit and a power combining method that is capable of suppressing and absorbing a spurious component generated by power amplification.

### [Solution to Problem]

In order to solve the above problem, a power combining circuit and a power combining method according to the present invention mainly include the following distinguishing configuration.
(1) A power combining circuit according to the present invention is a power combining circuit according to claim 1.
(2) A power combining method according to claim 6.

### [Advantageous Effect of Invention]

According to the power combining circuit and the power combining method of the present invention, the following advantageous effects are obtained.

As a first advantageous effect, newly providing the filters makes it possible to securely impart the filter effect for removing a spurious component in power combining, and to securely prevent an unwanted spurious component from being output to an antenna.

As a second advantageous effect, it is possible to suppress and absorb a spurious component generated in the amplifier by a terminator, without reflection on the filters and without returning to the amplifier. Thus, the above configuration is advantageous in securely preventing failure of the amplifier.

### [Brief Description of Drawings]

Fig. 1 is a block configuration diagram illustrating an example of an internal configuration of a power combining circuit according to the present invention;
Fig. 2 is a schematic diagram for describing an example of an operation to be performed by a power combining circuit illustrated in Fig. 1 as an exemplary embodiment of the invention; and
Fig. 3 is an explanatory diagram illustrating a concept of a filter having an impedance transformation function, in which first and second impedance transformation lines, and first and second filters in the power combining circuit illustrated in Fig. 1 are respectively integrated.

### [Description of Embodiments]

Hereinafter, a preferred exemplary embodiment of a power combining circuit and a power combining method according to the present invention is described referring to the accompanying drawings.

### (Features of the Present Invention)

Prior to description of an exemplary embodiment of the present invention, an outline of the features of the present invention is described. The present invention is an invention particularly relating to a power combining circuit and a power combining method for use in a high frequency band such as a VHF band or a UHF band, for instance, a power combining circuit and a power combining method for use in operating high frequency power units such as a power amplifier, a power distributor, a power combiner, and a filter circuit in a TV transmitter, an FM transmitter, or the like in parallel. The main features of the invention are such that it is possible to impart the characteristics of a filter to the power combining circuit, and it is possible to absorb a spurious signal component signal reflected on the filter by a terminator, without returning to an amplifier (an amplifier constituted of e.g. an FET (Field Effect Transistor) circuit).

More specifically, the invention includes the following configuration. Each of the signals to be output from 1st to n-th amplifiers PA1 to PAn (where n is a positive integer of 2 or more) constituting a power combining circuit is distributed to two signals by 1st, 2nd, ..., and n-th hybrid circuits HYB1, HYB2, ..., and HYBn, each of which has a coupling degree of 3 dB. In distributing the signals, each of the signals is distributed to two signals with the same amplitude. However, in comparison with the phase of a signal to be output to one of the terminals (e.g. a terminal 3), the phase of a signal to be output to the other one of the terminals (e.g. a terminal 4) has a -90 degree phase delay.

Subsequently, two signals obtained by combining powers in phase with each other in a signal group having a 0-degree phase component, and in a signal group having a -90 degree phase delay component are respectively input to filters newly provided for removing a spurious component. After removal of a spurious component, the two signals that have passed through the respective filters are power-combined by a 0th hybrid circuit HYB0 having a coupling degree of 3 dB for outputting to an antenna.

The filters for removing a spurious component are disposed at positions where impedance transformation is necessary when signals of the branching number n (where n is a positive integer of 2 or more), which are in phase with each other, are power-combined. Further, it is possible to configure a filter having an impedance transformation function, in which the impedance of an input port of the filter is set to (ZΩ/n), and the impedance of an output port of the filter is adjusted to ZΩ (where Z is a constant that is arbitrarily set in advance as a matching impedance value).

### (Configuration Example of Exemplary Embodiment)

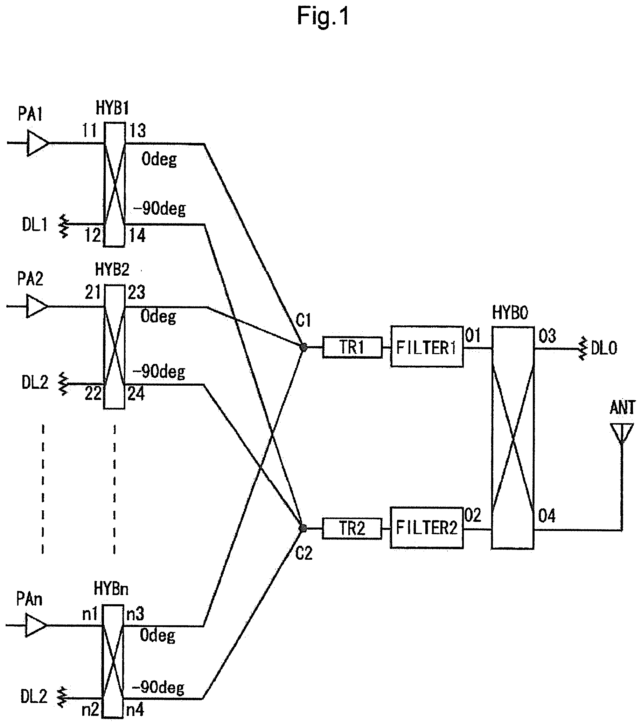

Next, an example of an internal configuration of the power combining circuit capable of suppressing and absorbing a spurious component, as an exemplary embodiment of the present invention, is described using the block configuration illustrated in Fig. 1. Fig. 1 is a block configuration diagram illustrating an example of an internal configuration of a power combining circuit according to the present invention, particularly, a power combining circuit for use in a high frequency band such as a VHF band or a UHF band, for instance, a power combining circuit for use in operating high frequency power units such as a power amplifier, a power distributor, a power combiner, and a filter circuit in a TV transmitter, an FM transmitter, or the like in parallel.

The power combining circuit illustrated in Fig. 1 includes at least 1st, 2nd, ... , and n-th amplifiers (power amplifiers) PA1, PA2, ... , and PAn (where n is a positive integer of 2 or more); 1st, 2nd, ... , and n-th hybrid circuits (3dB-hybrid circuits) HYB1, HYB2, ... , and HYBn; 1st, 2nd, ... , and n-th terminators DL1, DL2, ... , and DLn; first and second couplers C1 and C2; first and second impedance transformation lines TR1 and TR2; first and second filters FILTER1 and FILTER2; a 0th hybrid circuit (a back-end positioned hybrid circuit) HYB0; a 0th terminator (a back-end positioned terminator) DL0; and an antenna ANT.

In the power combining circuit illustrated in Fig. 1, outputs from the 1st, 2nd, ..., and n-th amplifiers (power amplifiers) PA1, PA2, ... , and PAn are respectively input to 11-th, 21-th, ... , and n1-th input terminals 11, 21, ... , and n1 of the 1 st, 2nd, ... , and n-th hybrid circuits HYB 1, HYB2, ... , and HYBn (3dB-hybrid circuits), each of which has a coupling degree of 3 dB. The 1st, 2nd, ... , and n-th terminators DL1, DL2, ... , and DLn are respectively connected to 12-th, 22-th, ... , and n2-th isolation terminals 12, 22, ... , and n2 of the 1st, 2nd, ... , and n-th hybrid circuits HYB1, HYB2, ... , and HYBn.

Further, 13-th, 23-th, ... , and n3-th output terminals 13, 23, ... , and n3 of the 1st, 2nd, ... , and n-th hybrid circuits HYB1, HYB2, ... , and HYBn for use in outputting a 0-degree phase signal are mutually connected to each other at the first coupler C1. A characteristic impedance of the line at the position of the first coupler C1 is set to (Z/n)Ω (where Z is a constant that is arbitrarily set in advance as a matching impedance value, e.g., "50"). However, the characteristic impedance is transformed to the matching impedance ZΩ at a final stage via the first impedance transformation line TR1. Thus, the first coupler C1 is connected to the first filter FILTER1. Likewise, 14-th, 24-th, ... , and n4-th output terminals 14, 24, ... , and n4 of the 1 st, 2nd, ... , and n-th hybrid circuits HYB1, HYB2, ... , and HYBn for use in outputting a -90 degree phase delay signal are mutually connected to each other at the second coupler C2. The characteristic impedance of the line at the position of the second coupler C2 is transformed to the matching impedance ZΩ at a first stage via the second impedance transformation line TR2, as well as the case of the first impedance transformation line TR1. Thus, the second coupler C2 is connected to the second filter FILTER2.

After the impedance transformation into the matching impedance ZΩ, e.g. 50Ω, via the respective first and second impedance transformation lines TR1 and TR2, the respective signals are input to the first and second filters FILTER1 and FILTER2 having the same electrical characteristics. The output terminals of the first and second filters FILTER1 and FILTER2 are respectively connected to 01-th and 02-th input terminals 01 and 02 of the back-end positioned hybrid circuit i.e. the 0th hybrid circuit HYB0 having a coupling degree of 3 dB.

A 03-th isolation terminal 03 of the 0th hybrid circuit HYB0 is connected to the back-end positioned terminator i.e. the 0th terminator DL0 for terminating an unwanted signal component to be output from the first and second filters FILTER1 and FILTER2. A 04-th output terminal 04, which combines the signal components to be output from the first and second filters FILTER1 and FILTER2 for output, is connected to the antenna ANT.

According to the internal configuration as described above, the power combining circuit illustrated in Fig. 1 is capable of suppressing and absorbing a spurious component generated in the 1st, 2nd, ... , and n-th amplifiers PA1, PA2, ... , and PAn by the 1st, 2nd, ... , and n-th terminators DL1, DL2, ... , and DLn, without reflection on the first and second filters FILTER1 and FILTER2, and without returning to the 1st, 2nd, ... , and n-th amplifiers PA1, PA2, ... , and PAn. Thus, it is possible to securely prevent failure of the 1st, 2nd, ... , and n-th amplifiers PA1, PA2, ... , and PAn (amplifiers each constituted of e.g. an FET circuit), which may occur resulting from reflection.

### (Description on Operation of Exemplary Embodiment)

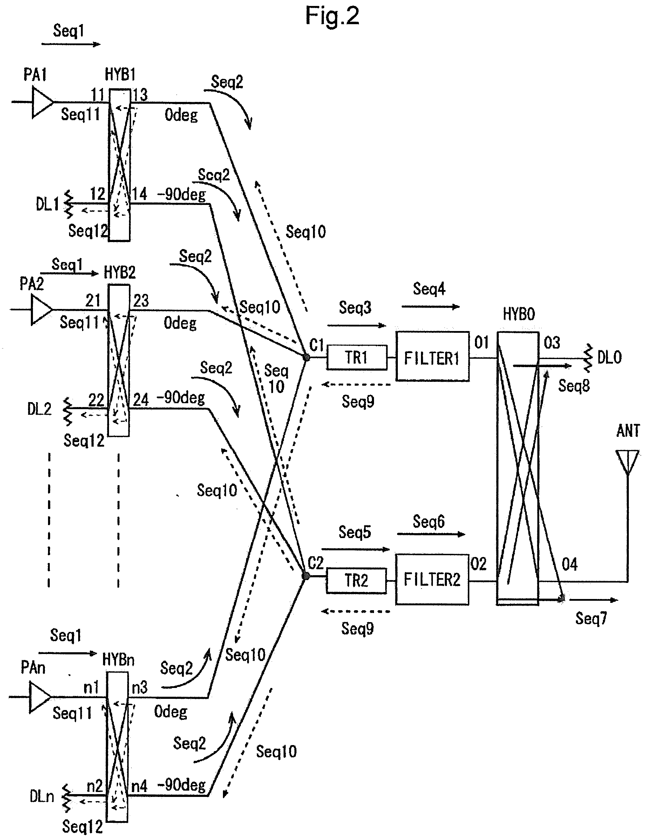

Next, an operation to be performed by the power combining circuit illustrated in Fig. 1 is described in detail referring to the schematic diagram of Fig. 2. Fig. 2 is a schematic diagram for describing an example of an operation to be performed by the power combining circuit described as an exemplary embodiment of the present invention in Fig. 1. Fig. 2 illustrates an example of an operation of securely preventing reflection of a spurious component generated in the 1 st, 2nd, ... , and n-th amplifiers PA1, PA2, ... , and PAn on the first and second filters FILTER1 and FILTER 2, and returning of the spurious component to the 1st, 2nd, ... , and n-th amplifiers PA1, PA2, ... , and PAn.

As illustrated in the schematic diagram of Fig. 2, high frequency signals is power-amplified in the 1st, 2nd, ... , and n-th amplifiers PA1, PA2, ... , and PAn having the same frequencies as each other, and in phase with each other, are respectively input to the 11-th, 21-th, ... , and n1-th input terminals 11, 21, ... , and n1 (where n is a positive integer of 2 or larger) of the 1 st, 2nd, ... , and n-th hybrid circuits HYB1, HYB2, ... , and HYBn, each of which has a coupling degree of 3 dB (sequence Seq1).

Each of the high frequency signals input from the 1 st, 2nd, ... , and n-th amplifiers PA1, PA2, ... , and PAn is distributed to two signals, and the respective two signals are output, as output signals of the same amplitude, to the 13-th, 23-th, ... , and n3-th output terminals 13, 23, ... , and n3 of the 1 st, 2nd, ... , and n-th hybrid circuits HYB1, HYB2, ... , and HYBn, and to the 14-th, 24-th, ... , and n4-th output terminals 14, 24, ... , and n4 of the 1st, 2nd, ... , and n-th hybrid circuits HYB1, HYB2, ... , and HYBn. When the signals are output, the phases of the signals to be output to the 14-th, 24-th, ... , and n4-th output terminals 14, 24, ... , and n4 respectively have a -90 degree phase delay with respect to the phases of the signals to be output to the 13-th, 23-th, ... , and n3-th output terminals 13, 23, ... , and n3 (sequence Seq2).

The signals distributed to the 13-th, 23-th, ... , and n3-th output terminals 13, 23, ... , and n3 are guided to the first coupler C1. The characteristic impedance of the line at the position of the first coupler C1 is set to (Z/n)Ω. However, impedance transformation is performed until the matching impedance ZΩ is obtained by the line of the first impedance transformation line TR1 before the signal reaches the input terminal of the first filter FILTER1 from the first coupler C1 (sequence Seq3). Thereafter, the signal that has passed through the first filter FILTER1 for removing a spurious component is guided to a 01-th input terminal 01 of the back-end positioned hybrid circuit i.e. the 0th hybrid circuit HYB0 (sequence Seq4).

Further, the signals having a -90 degree phase delay distributed to the 14-th, 24-th, ... , and n4-th output terminals 14, 24, ... , and n4 are guided to the second coupler C2. The characteristic impedance of the line at the position of the second coupler C2 is set to (Z/n)Ω. However, as well as the case of the first coupler C1, impedance transformation is performed until the matching impedance ZΩ is obtained by the line of the second impedance transformation line TR2 before the signal reaches the input terminal of the second filter FILTER2 from the second coupler C2 (sequence Seq5). Thereafter, the signal that has passed through the second filter FILTER2 for removing a spurious component is guided to a 02-th input terminal 02 of the back-end positioned hybrid circuit i.e. the 0th hybrid circuit HYB0 (sequence Seq6).

A phase difference between the signal guided to the 01-th input terminal 01 of the back-end positioned hybrid circuit i.e. the 0th hybrid circuit HYB0, and the signal guided to the 02-th input terminal 02 of the 0th hybrid circuit HYB0 is 90 degrees (in other words, the signal on the 02-th input terminal 02 is a signal having a -90 degree phase delay with respect to the signal on the 01-th input terminal 01). Therefore, power combining is performed on the side of the 04-th output terminal 04 of the 0th hybrid circuit HYB0, which is connected to the antenna ANT, and a signal is output to the antenna ANT (sequence Seq7). On the other hand, the phase of combined power is reversed on the side of the 03-th isolation terminal 03, which is connected to the back-end positioned terminator i.e. the 0th terminator DL0 so that power is not output from the 0th terminator DL0 (sequence Seq8).

A spurious component that is unable to pass through the first and second filters FILTER1 and FILTER2 is respectively reflected on the first and second filters FILTER1 and FILTER2, and respectively returns to the first and second couplers C1 and C2 via the first and second impedance transformation lines TR1 and TR2 (sequence Seq9). Thereafter, the reflected spurious component respectively returns from the first coupler C1 and the second coupler C2 to the 13-th, 23th, ... , and n3-th output terminals 13, 23, ... , and n3 of the 1st, 2nd, ... , and n-th hybrid circuits HYB1, HYB2, ... , and HYBn, and to the 14-th, 24-th, ... , and n4-th output terminals 14, 24, ... , and n4 of the 1 st, 2nd, ... , and n-th hybrid circuits HYB1, HYB2, ... , and HYBn (sequence Seq10).

A phase difference between a reflected signal with respect to the 13-th, 23-th, ... , and n3-th output terminals 13, 23, ... , and n3 of the 1st, 2nd, ... , and n-th hybrid circuits HYB1, HYB2, ... , and HYBn, and a reflected signal with respect to the 14-th, 24-th, ... , and n4-th output terminals 14, 24, ... , and n4 of the 1st, 2nd, ... , and n-th hybrid circuits HYB1, HYB2, ... , and HYBn is 90 degrees. The phase of reflected power is reversed on the side of the 11-th, 21-th, ... , and n1-th input terminals 11, 21, ... , and n1 of the 1st, 2nd, ... , and n-th hybrid circuits HYB1, HYB2, ... , and HYBn to which the 1st, 2nd, ... , and n-th amplifiers PA1, PA2, ... , and PAn are respectively connected so that power of the reflected spurious component is not output (sequence Seq11).

On the other hand, on the side of the 12-th, 22-th, ... , and n2-th isolation terminals 12, 22, ... , and n2 of the 1st, 2nd, ... , and n-th hybrid circuits HYB1, HYB2, ... , and HYBn to which the 1st, 2nd, ... , and n-th terminators DL1, DL2, ... , and DLn are respectively connected, a reflected spurious component is output to the 1st, 2nd, ... , and n-th terminators DL1, DL2, ..., and DLn; and power is absorbed by the 1st, 2nd, ... , and n-th terminators DL1, DL2, ... , and DLn (sequence Seq12).

According to the aforementioned operation, the power combining circuit illustrated in Fig. 1 is capable of suppressing and absorbing a spurious component generated in the 1st, 2nd, ... , and n-th amplifiers PA1, PA2, ... , and PAn by the 1st, 2nd, ... , and n-th terminators DL1, DL2, ... , and DLn, without reflection on the first and second filters FILTER1 and FILTER2, and without returning to the 1st, 2nd, ... , and n-th amplifiers PA1, PA2, ... , and PAn.

It is needless to say that, also in the exemplary embodiment, the isolation function between a plurality of amplifiers (amplifiers each constituted of e.g. an FET (Field Effect Transistor) circuit) provided in a conventional power combining circuit (in other words, a function to absorb power from an amplifier by a terminator and to prevent returning of reflected power to the other amplifiers, even if a failure occurs in the amplifier) is implemented substantially in the same manner by the 1st, 2nd, ... , and n-th terminators DL1, DL2, ... , and DLn respectively connected to the 12-th, 22-th, ... , and n2-th isolation terminals 12, 22, ... , and n2 of the 1st, 2nd, ... , and n-th hybrid circuits HYB1, HYB2, ... , and HYBn.

Further, it is also needless to say that the first and second filters FILTER1 and FILTER2 for removing a spurious component are not limited to a band-pass filter configured to pass only a signal component in an intended frequency band. The same configuration as described above is also applicable to a low-pass filter configured to pass a low frequency signal component in a frequency band equal to or lower than an intended frequency band, and to a high-pass filter configured to pass a high frequency signal component in a frequency band equal to or higher than an intended frequency band.

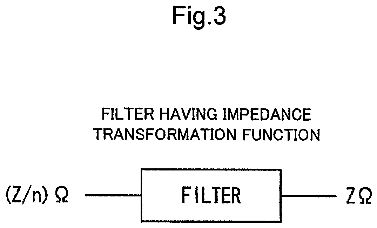

Further, it is possible to provide a circuit configuration as illustrated in Fig. 3, in which first and second impedance transformation lines TR1 and TR2 which perform impedance transformation from the characteristic impedance (Z/n)Ω of the line to the matching impedance ZΩ, and first and second filters FILTER1 and FILTER2 for removing a spurious component are respectively integrated. Fig. 3 is an explanatory diagram illustrating a concept of a filter having an impedance transformation function, in which the first and second impedance transformation lines TR1 and TR2, and the first and second filters FILTER1 and FILTER2 in the power combining circuit illustrated in Fig. 1 are respectively integrated. Specifically, the filter having an impedance transformation function illustrated in Fig. 3 is provided with an impedance transformation function of performing impedance transformation inside the circuit so that the impedance of the output port is equal to the matching impedance ZΩ, regardless that the impedance of the input port is set to (Z/n)Ω, in addition to the filtering function for removing a spurious component. The above configuration makes it possible to miniaturize the power combining circuit.

Further, the power combining circuit illustrated in Fig. 1 is a power combining circuit for combining high frequency powers having arbitrary frequencies, wherein an amplifier which amplifies an input high frequency power, and a 3dB-hybrid circuit which distributes the output from the amplifier to two signals having a phase difference of 90 degrees from each other are respectively constituted of a plurality of circuits i.e. the 1st, 2nd, ... , and n-th amplifiers PA1, PA2, ... , and PAn, and the 1 st, 2nd, ... , and n-th hybrid circuits HYB1, HYB2, ... , and HYBn. The present invention is not limited to the above configuration. Each of the amplifier and the 3dB-hybrid circuit may be constituted of one circuit in some cases.

### (Description on Advantageous Effects of Exemplary Embodiment)

The exemplary embodiment has overcome the drawbacks of the conventional power combining circuit, and provides the following advantageous effects.

As a first advantageous effect, providing the first and second filters FILTER1 and FILTER2 is advantageous in securely imparting the filter effect for removing a spurious component in power combining, and in securely preventing an unwanted spurious component from being output to the antenna ANT.

As a second advantageous effect, it is possible to suppress and absorb a spurious component generated in the 1st, 2nd, ... , and n-th amplifiers PA1, PA2, ... , and PAn by the 1st, 2nd, ... , and n-th terminators DL1, DL2, ... , and DLn, without reflection on the first and second filters FILTER1 and FILTER2, and without returning to the 1st, 2nd, ... , and n-th amplifiers PA1, PA2, ... , and PAn. Thus, it is possible to securely prevent failure of the 1st, 2nd, ... , and n-th amplifiers PA1, PA2, ... , and PAn.

The configuration of a preferred embodiment of the present invention has been described as above. Note that the exemplary embodiment is merely an example of the present invention, and does not limit the invention.

### [Reference Signs List]

- 01: 01-th input terminal
- 02: 02-th input terminal
- 03: 03-th isolation terminal
- 04: 04-th output terminal
- 11: 11-th input terminal
- 12: 12-th isolation terminal
- 13: 13-th output terminal
- 14: 14-th output terminal
- 21: 21-th input terminal
- 22: 22-th isolation terminal
- 23: 23-th output terminal
- 24: 24-th output terminal
- n1: n1-th input terminal
- n2: n2-th isolation terminal
- n3: n3-th output terminal
- n4: n4-th output terminal
- ANT: antenna
- C1: first coupler
- C2: second coupler
- DL0: 0th terminator (back-end positioned terminator)
- DL1: 1st terminator
- DL2: 2nd terminator
- DLn: n-th terminator
- FILTER1: first filter
- FILTER2: second filter
- HYB0: 0th hybrid circuit (back-end positioned hybrid circuit)
- HYB1: 1st hybrid circuit
- HYB2: 2nd hybrid circuit
- HYBn: n-th hybrid circuit
- PA1: 1st amplifier (first power amplifier)
- PA2: 2nd amplifier (second power amplifier)
- PAn: n-th amplifier (n-th power amplifier)
- TR1: first impedance transformation line
- TR2: second impedance transformation line

## Claims

1. A power combining circuit comprising at least:
a plurality of amplifiers (PA1∼PAn), each of which amplifies input high frequency powers;
a plurality of 3dB-hybrid circuits (HYB1∼HYBn), each of which distributes an output from the corresponding amplifier (PA1∼PAn) to two signals having a phase difference of 90 degrees from each other;
two couplers (C1, C2), each of which couples signals in phase with each other, among the two signals output from each of the 3dB-hybrid circuits (HYB1∼HYBn);
two filters (FILTER 1, FILTER 2) which remove a spurious component included in each of the signals coupled by the two couplers (C1, C2); and
a back-end positioned hybrid circuit (HYB0) which power-combines the signals from the two filters (FILTER 1, FILTER 2) for output, **characterized in that** the power combining circuit further comprises:
two impedance transformation lines (TR1, TR2), each of which transforms a characteristic impedance of the line to a predetermined matching impedance, the impedance transformation lines (TR1, TR2) being connected between the two couplers (C1, C2) and the two filters (FILTER 1, FILTER 2).

2. The power combining circuit according to Claim 1, wherein
each of the two filters (FILTER 1, FILTER 2) internally includes a circuit which transforms a characteristic impedance of a line on an input terminal side to a predetermined matching impedance for output.

3. The power combining circuit according to Claim 1 or 2, wherein
the two filters (FILTER 1, FILTER 2) are constituted of a band-pass filter, a low-pass filter, or a high-pass filter.

4. The power combining circuit according to any one of Claims 1 to 3, wherein
an isolation terminal of the 3dB-hybrid circuit (HYB1∼HYBn) is connected to a terminator (DL1∼DLn) for terminating a spurious component reflected on the two filters (FILTER 1, FILTER 2).

5. The power combining circuit according to any one of Claims 1 to 4, wherein
an isolation terminal of the back-end positioned hybrid circuit (HYB0) is connected to a back-end positioned terminator (DL0) for terminating an unwanted signal component output from the two filters (FILTER 1, FILTER 2).

6. A power combining method, comprising at least:
after distributing an output from the amplifier (PA1∼PAn) to two signals having a phase difference of 90 degrees from each other by a 3dB-hybrid circuit (HYB1∼HYBn), filtering the two signals for removing a spurious component included in each of the two signals in order to remove the spurious component generated when an input high frequency power is amplified by the amplifier, **characterized in that** the power combining method further comprises:
transforming a characteristic impedance of each of two impedance transformation lines (TR1, TR2) to a predetermined matching impedance, the impedance transformation lines (TR1, TR2) being connected between two couplers (C1, C2), and two filters (FILTER 1, FILTER 2).

## Patentansprüche

1. Leistungssummiererschaltung, die mindestens aufweist:
mehrere Verstärker (PA1∼PAn), von denen jeder Eingangshochfrequenzleistungen verstärkt;
mehrere 3dB-Hybridschaltungen (HYB1∼HYBn), von denen jede eine Ausgabe aus dem entsprechenden Verstärker (PA1∼PAn) auf zwei Signale verteilt, die eine Phasendifferenz von 90 Grad zueinander aufweisen;
zwei Koppler (C1, C2), von denen jeder zueinander gleichphasige Signale aus den beiden Signalen koppelt, die aus jeder der 3dB-Hybridschaltungen (HYB1∼HYBn) ausgegeben werden;
zwei Filter (FILTER 1, FILTER 2), die einen Störanteil entfernen, der in jedem der Signale enthalten ist, die durch die beiden Koppler (C1, C2) gekoppelt werden; und
eine nachgeschaltet angeordnete Hybridschaltung (HYB0), die die Signale aus den beiden Filtern (FILTER 1, FILTER 2) zur Ausgabe leistungssummiert,
**dadurch gekennzeichnet, dass** die Leistungssummiererschaltung ferner aufweist:
zwei Impedanztransformationsleitungen (TR1, TR2), von denen jede eine charakteristische Impedanz der Leitung in eine vorgegebene Anpassungsimpedanz transformiert,
wobei die Impedanztransformationsleitungen (TR1, TR2) zwischen die beiden Koppler (C1, C2) und die beiden Filter (FILTER 1, FILTER 2) geschaltet sind.

2. Leistungssummiererschaltung nach Anspruch 1, wobei
jeder der beiden Filter (FILTER 1, FILTER 2) intern eine Schaltung aufweist, die eine charakteristische Impedanz einer Leitung auf einer Eingangsanschlussseite auf eine vorgegebene Anpassungsimpedanz zur Ausgabe transformiert.

3. Leistungssummiererschaltung nach Anspruch 1 oder 2, wobei
die beiden Filter (FILTER 1, FILTER 2) aus einem Bandpassfilter, einem Tiefpassfilter oder einem Hochpassfilter gebildet werden.

4. Leistungssummiererschaltung nach einem der Ansprüche 1 bis 3, wobei
ein Isolationsanschluss der 3dB-Hybridschaltung (HYB1∼HYBn) mit einem Abschlusswiderstand (DL1∼DLn) zum Abschließen eines Störanteils verbunden ist, der an den beiden Filtern (FILTER 1, FILTER 2) reflektiert wird.

5. Leistungssummiererschaltung nach einem der Ansprüche 1 bis 4, wobei
ein Isolationsanschluss der nachgeschaltet angeordneten Hybridschaltung (HYB0) mit einem nachgeschaltet angeordneten Abschlusswiderstand (DL0) zum Abschließen einer unerwünschten Signalkomponente verbunden ist, die aus den beiden Filtern (FILTER 1, FILTER 2) ausgegeben wird.

6. Leistungssummierungsverfahren, das mindestens aufweist:
nach dem Verteilen einer Ausgabe aus dem Verstärker (PA1∼PAn) auf zwei Signale, die eine Phasendifferenz von 90 Grad zueinander aufweisen, durch eine 3dB-Hybridschaltung (HYB1∼HYBn), Filtern der beiden Signale zum Entfernen eines Störanteils, der in jedem der beiden Signale enthalten ist, um den Störanteil zu entfernen, der erzeugt wird, wenn eine Eingangshochfrequenzleistung durch den Verstärker verstärkt wird,
**dadurch gekennzeichnet, dass**
das Leistungssummierungsverfahren ferner aufweist:
Transformieren einer charakteristischen Impedanz von jeweils zwei Impedanztransformationsleitungen (TR1, TR2) auf eine vorgegebene Anpassungsimpedanz, wobei die Impedanztransformationsleitungen (TR1, TR2) zwischen zwei Koppler (C1, C2), und zwei Filter (FILTER 1, FILTER 2) geschaltet sind.

## Revendications

1. Circuit de combinaison de puissance comprenant au moins :
une pluralité d'amplificateurs (PA1∼PAn), chacun de ceux-ci amplifiant des puissances d'entrée à haute fréquence ;
une pluralité de circuits hybrides 3dB (HYB1∼HYBn), chacun de ceux-ci répartissant une sortie de l'amplificateur (PA1∼PAn) correspondant en deux signaux présentant une différence de phase de 90° l'un par rapport à l'autre ;
deux coupleurs (C1, C2), chacun de ceux-ci couplant des signaux en phase l'un avec l'autre, parmi les deux signaux de sortie de chacun des circuits hybrides 3dB (HYB1-HYBn) ;
deux filtres (FILTER 1, FILTER 2) supprimant une composante non essentielle comprise dans chacun des signaux couplés par les deux coupleurs (C1, C2) ; et
un circuit hybride arrière (HYB0) combinant la puissance des signaux des deux filtres (FILTER 1, FILTER 2) pour sortie,
**caractérisé en ce que** circuit de combinaison de puissance comprend en outre :
deux lignes de transformation d'impédance (TR1, TR2), chacune de celles-ci transformant une impédance caractéristique de la ligne en une impédance d'adaptation définie, les lignes de transformation d'impédance (TR1, TR2) étant connectées entre les deux coupleurs (C1, C2) et les deux filtres (FILTER 1, FILTER 2).

2. Circuit de combinaison de puissance selon la revendication 1, où
chacun des deux filtres (FILTER 1, FILTER 2) comprend un circuit interne qui transforme une impédance caractéristique d'une ligne sur un côté terminal d'entrée en une première impédance d'adaptation définie pour sortie.

3. Circuit de combinaison de puissance selon la revendication 1 ou la revendication 2, où les deux filtres (FILTER 1, FILTER 2) se composent d'un filtre passe-bande, d'un filtre passe-bas ou d'un filtre passe-haut.

4. Circuit de combinaison de puissance selon l'une des revendications 1 à 3, où
un terminal d'isolation du circuit hybride 3dB (HYB1∼HYBn) est relié à un terminateur (DL1∼DLn) pour supprimer une composante non essentielle réfléchie sur les deux filtres (FILTER 1, FILTER 2).

5. Circuit de combinaison de puissance selon l'une des revendications 1 à 4, où
un terminal d'isolation du circuit hybride arrière (HYB0) est relié à un terminateur arrière (DL0) pour supprimer une composante de signal indésirable sortie des deux filtres (FILTER 1, FILTER 2).

6. Procédé de combinaison de puissance, comprenant au moins :
après répartition d'une sortie de l'amplificateur (PA1∼PAn) en deux signaux présentant une différence de phase de 90° l'un par rapport à l'autre par un circuit hybride 3dB (HYB1∼HYBn), le filtrage des deux signaux pour supprimer une composante inessentielle comprise dans chacun des deux signaux afin de supprimer la composante inessentielle générée quand une puissance d'entrée à haute fréquence est amplifiée par l'amplificateur,
**caractérisé en ce que** ledit procédé de combinaison de puissance comprend en outre : la transformation d'une impédance caractéristique de chacune de deux lignes de transformation d'impédance (TR1, TR2) en une impédance d'adaptation définie, les lignes de transformation d'impédance (TR1, TR2) étant connectées entre deux coupleurs (C1, C2) et deux filtres (FILTER 1, FILTER 2).
